# EUROPÄISCHE PATENTSCHRIFT

(11) **EP 1 232 293 B1**
(45) Veröffentlichungstag und Bekanntmachung des Hinweises auf die Patenterteilung: **14.05.2003**
(21) Anmeldenummer: 00977458.9
(22) Anmeldetag: 02.11.2000
(51) Int. Cl.: C23C 14/00

(54) **VERFAHREN ZUR REGELUNG VON SPUTTERPROZESSEN**
METHOD FOR REGULATING SPUTTERING PROCESSES
PROCEDE POUR REGULER LES PROCESSUS DE PULVERISATION CATHODIQUE

(30) Priorität: 25.11.1999 DE 19956733
(43) Veröffentlichungstag der Anmeldung: 21.08.2002
(73) Patentinhaber: FRAUNHOFER-GESELLSCHAFT ZUR FÖRDERUNG DER ANGEWANDTEN FORSCHUNG E.V., 80636 München (DE)
(72) Erfinder: SZYSZKA, Bernd, 38108 Braunschweig (DE); MALKOMES, Niels, 38106 Braunschweig (DE)
(74) Vertreter: Gleiter, Hermann
(86) Internationale Anmeldenummer: EP0010782
(87) Internationale Veröffentlichungsnummer: WO01038597

(56) Entgegenhaltungen:
- EP-A- 0 501 016
- US-A- 5 939 886
- SOBOLEWSKI M A ET AL: "Electrical measurements for monitoring and control of RF plasma processing" ADVANCED TECHNIQUES FOR INTEGRATED CIRCUIT PROCESSING II, SAN JOSE, CA, USA, 21-23 SEPT. 1992, Bd. 1803, Seiten 309-320, XP000987027 Proceedings of the SPIE - The International Society for Optical Engineering, 1993, USA ISSN: 0277-786X

## Beschreibung

Die vorliegende Erfindung bezieht sich auf ein Verfahren zur Regelung von MF- oder HF-Sputterprozessen. Plasmasputtern und ist eine etablierte Technologie für die Beschichtung von Substraten, insbesondere mit keramischen oder anderen mehrkomponentigen Funktionsschichten. Das Sputtern, insbesondere das reaktive Magnetronsputtern basiert auf dem Sputtern von metallischen Targets in einer reaktiven Atmosphäre mit dem Ziel, auf dem Substrat die gewünschte Verbindung mit der gewünschten Mikrostruktur und Phasenzusammensetzung bei hoher Rate aufwachsen zu lassen.

Ein wesentliches Problem resultiert jedoch daraus, daß der Reaktivgas-Partialdruck in konventionellen Sputterprozessen nicht stetig verändert werden kann. Der Parameterraum zerfällt daher in die definierten Bereiche "Compound Mode" mit hohem Reaktivgas-Partialdruck und einer vollständig mit Reaktionsprodukten bedeckten Targetoberfläche sowie stöchiometrischen Schichten am Substrat und einem "Metallic Mode" mit einem geringen Reaktivgas-Partialdruck in der Sputterkammer, einer weitgehend metallischen Targetoberfläche und dem Aufwachsen von metallischen Schichten auf dem Substrat. Zwischen diesen Bereichen ist im allgemeinen kein stetiger Übergang möglich, es resultieren vielmehr instabile Prozeßzustände, deren Zustandekommen im folgenden skizziert wird. Dabei wird beispielhaft auf das Reaktivgas O₂ Bezug genommen, die angeführten Mechanismen gelten jedoch auch für Sputtern in N₂, CHₓ und dgl.

Zu Beginn des Magnetronsputterns wird Reaktivgas in die Sputterkammer zugegeben. Daraufhin laufen auf der Targetoberfläche konkurrierende Wachstums- und Ätzprozesse ab. Bei niedrigem O₂-Partialdruck ist die Rate für das Aufwachsen der Oxidbedeckung gering, so daß der Ätzprozeß durch den Sputterabtrag der Oxidschicht überwiegt. Die Targetoberfläche bleibt daher insgesamt metallisch. Dieser Zustand ist stabil, da das Target als effiziente Getterpumpe arbeitet, deren effektives Saugvermögen oftmals ein Vielfaches des Saugvermögens der eigentlich zur Evakuierung eingesetzten Turbopumpe beträgt.

Wird der Reaktivgas-Partialdruck erhöht, so wächst auf der Targetoberfläche eine Oxidschicht mit etwas höherer Rate auf. Bei geringen Ionenstromdichten und somit geringer Ätzrate überwiegt dann der Wachstumsprozeß. Auf diese Weise entstehen mit Reaktionsprodukten bedeckte Targetbereiche, die auch als "vergiftete Targetbereiche" bezeichnet werden.

Diese vergifteten Targetbereiche weisen gegenüber dem Metall stets eine geringere Sputterausbeute auf, so daß insgesamt weniger Targetmaterial gesputtert wird. Dies führt zu einer Abnahme des Materialabtrags am Target, einer Verminderung des Targetsaugvermögens und damit zu einer weiteren Erhöhung des Reaktivgas-Partialdrucks.

Sobald der Reaktivgas-Partialdruck einen kritischen Wert überschreitet, kommt es folglich zu einem selbstverstärkenden Effekt, da die Erhöhung des Reaktivgas-Partialdrucks eine Verminderung des Saugvermögens der Target-Getterpumpe zur Folge hat, woraus wiederum eine Erhöhung des Reaktivgas-Partialdrucks resultiert. Diese Instabilität kennzeichnet den Übergang vom Metallic Mode in den Compound Mode.

Technisch von großem Interesse ist nun gerade die Stabilisierung des unstetigen Übergangs zwischen diesen beiden Zuständen, da zum einen die Wachstumsrate im Compound Mode bedingt durch die niedrige Sputterausbeute nur gering ist, andererseits die Schichten im Compound Mode unter Reaktivgasüberschuß aufwachsen, woraus ungünstige Schichteigenschaften resultieren. Andererseits ist der Reaktivgas-Partialdruck im Metallic Mode im allgemeinen zu gering, so daß dann absorbierende unterstöchiometrische Verbindungen aufwachsen.

Die gewünschten stöchiometrischen Schichten können jedoch dann bei hoher Rate abgeschieden werden, wenn der Prozeß genau im instabilen Übergangsbereich, der auch als "Transition Mode" bezeichnet wird, betrieben wird. Die Stabilisierung dieses unstetigen Übergangszustandes "Transition Mode" ist durch Regelkreise möglich, die das dynamische Verhalten der Quellen berücksichtigen und die so die technisch interessanten instabilen Arbeitspunkte aufrechterhalten können.

Im Stand der Technik werden verschiedene Regelgrößen vorgeschlagen, um den Transition Mode zu stabilisieren.

Beispielsweise ist aus J. Affinito, R. R. Parsons, "Mechanisms of voltage controlled, reactive, planar magnetron sputtering of Al in Ar/N₂ and Ar/O₂ atmospheres", J. Vac. Sci. Technol. A 2 (1984) 1275 bekannt, das für Materialien wie ZnO, SnO₂ oder SiO₂, bei welchen die Plasmaimpedanz signifikant von der Targetbedeckung abhängt, die Plasmaimpedanz als Regelgröße durch die Anpassung der Entladungsleistung oder des Reaktivgasflusses konstant hält (Impedanzregelung). Alternativ wurde durch die EP 0 795 623 A1 (Veröffentlichung 17.09.1997) vorgeschlagen, daß in oxidischen Systemen, bei denen die Plasmaimpedanz nur geringfügig von der Targetbedeckung abhängt, so daß die Impedanzregelung versagt wie beispielsweise für TiO₂, Nb₂O₅, als Regelgröße der Reaktivgas-Partialdruck verwendet wird, welcher über Lambdasonden bestimmt wird.

Die Dissertation von J. Strümpfel, "Prozeßstabilisierung beim reaktiven Hochratenzerstäuben mittels optischer Emissionsspektroskopie zur industriellen Herstellung von Indium-Zinn-Oxidschichten und Titandioxidschichten", Chemnitz, 1991 beschreibt als weitere Möglichkeit die Verwendung der optischen Emission der Plasmaentladung als Regelgröße. Auch eine Kombination der oben genannten Verfahren aus dem Stand der Technik sind einsetzbar. Alle die oben genannten Verfahren sind auch prinzipiell sowohl im Gleichspannungsals auch im MF-Betrieb einsetzbar.

Alle die genannten Verfahren aus dem Stand der Technik bestimmen absolute Größen. Eine derartige Bestimmung von absoluten Größen ist jedoch unter Produktionsbedingungen sehr problematisch. Denn beispielsweise ändert sich die Plasmaimpedanz durch die Targeterrosion, durch Kontamination der Meßköpfe, durch wilde Schichten und dgl.

Aufgabe der vorliegenden Erfindung ist es daher, ein Verfahren zur Regelung von Sputterprozessen anzugeben, mit dem sich zuverlässig der Übergang zwischen den verschiedenen Betriebsmodi wie oben beschrieben, stabilisieren läßt.

Diese Aufgabe wird durch das Verfahren nach Anspruch 1 sowie die Vorrichtung nach Anspruch 7 gelöst. Vorteilhafte Weiterbildungen des erfindungsgemäßen Verfahrens werden in den abhängigen Ansprüchen gegeben.

Die vorliegende Erfindung eröffnet eine neue Methode zur Plasmadiagnostik und Charaktierisierung des Targetzustandes über die harmonische Analyse der elektrischen Entladungsparameter. Hierzu gehört beispielsweise die Analyse des komplexen Fourierspektrums der elektrischen Entladungsparameter, wie Kathodenstrom oder Kathodenspannung. Damit werden neue Möglichkeiten der Prozeßregelung geschaffen. Als Stellwert bieten sich beispielsweise die Oberwellenanteile von Strom und Spannung, die Phasenverschiebung zwischen Strom und Spannung bei der Fundamentalfrequenz und/oder bei höheren Frequenzen oder auch die Verhältnisse der Fourierkoeffizienten von Strom und Spannung der Kathode an.

Der besondere Vorteil des erfindungsgemäßen Verfahrens besteht darin, daß der Targetzustand bestimmt werden kann, ohne daß Absolutwerte präzise bestimmt werden müssen.

Im folgenden werden einige Beispiele des erfindungsgemäßen Verfahrens beschrieben.

Die Figuren 1 und 2 zeigen die harmonische Analyse und den U(q_{O2})-Hystereseverlauf beim reaktiven Magnetronsputtern von TiOₓ-Schichten.

Die Figuren 3 und 4 zeigen die Abhängigkeit einer Stellgröße von dem Gesamtdruck in der Sputterkammer beim Nb₂O₅-Sputtern.

Figur 5 zeigt die Abhängigkeit des normierten Fourierkoeffizienten u1/U von der Entladungsleistung beim Nb₂O₅-Sputtern.

Figur 6 zeigt die Abbildung von Brechungsindex n, Absorptionskoeffizient k und Depositionsrate a von den normierten Fourierkoeffizienten u1/U beim Nb₂O₅-Sputtern.

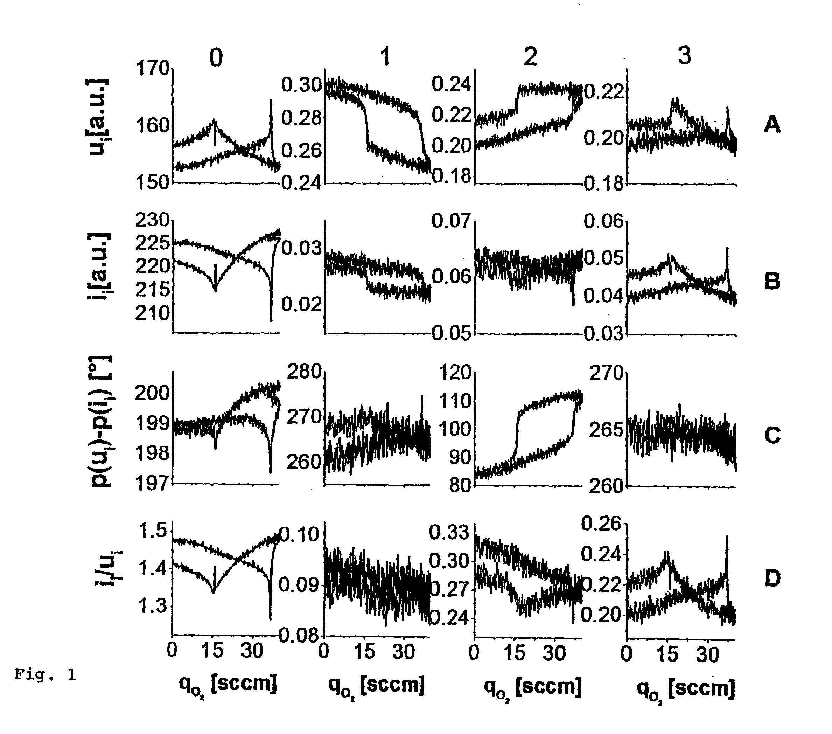

Im folgenden werden die Ergebnisse einer Beobachtung der elektrischen Parameter der Entladung für das reaktive MF-Magnetronsputtern von TiOₓ-Schichten beschrieben. Dabei zeigt Fig. 1 die harmonische Analyse der Hysterese beim reaktiven Mittelfrequenz-Magnetronsputttern der TiOₓ-Schichtsystemen. Die Prozeßführung erfolgte bei konstanter Leistung von P = 6 kW entsprechend einer Leistungsdichte von P/A = 7 W/cm² und bei konstantem Ar-Fluß von q_{Ar} = 60 sccm. Beginnend von metallischen Targets wurde der O₂-Fluß stetig im Bereich von q_{O2} = O...40 sccm erhöht bzw. abgesenkt. Die Zeilen A-D der Matrix stellen die Fourierkoeffizienten von Strom und Spannung uⱼ und iᵢ, die Phasenverschiebung zwischen Spannung und Strom p(uᵢ)-p(iᵢ) und das Verhältnis der Fourierkoeffizienten iᵢ/uᵢ dar. Die Spalten 0-3 bezeichnen die Daten für die Grundschwingung und die erste bis dritte Oberwelle.

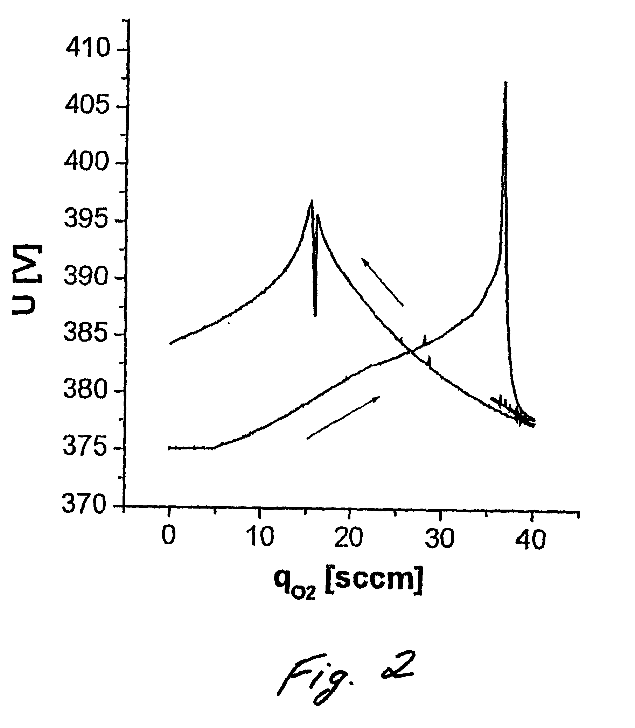

Das reaktive Sputtern von TiOₓ-Schichtsystemen ist klassisch nicht impedanzregelbar, da kein monotoner Zusammenhang zwischen Entladungsspannung und Targetzustand besteht. Abbildung 2 zeigt dazu die U(qₒ₂)-Kennlinie für den oben in Fig. 1 mittels harmonischer Analyse untersuchten Prozeß.

Der Verlauf entspricht im wesentlichen dem der Grundschwingung uₒ, die in Fig. 1 dargestellt ist, der Übergang zwischen den Betriebszuständen Metallic Mode und Oxide Mode erfolgt bei q_{O2} = 37 sccm bzw. qₒ₂ = 16 sccm, der Targetzustand kann nicht eindeutig anhand der Entladungsspannung identifiziert werden.

Die harmonische Analyse bietet solche eindeutige Zuordnungen für einige der in Fig. 1 aufgetragenen Größen. Für die Stabilisierung des TiOₓ-Prozesses bietet sich besonders die Analyse der Phasenverschiebung von Spannung und Strom der zweiten Oberwelle an (Abbildung C2 der Matrix in Fig. 1). Diese Größe ist aufgrund ihres hohen Signalhubs und aufgrund des geringen Rauschens hervorragend als Regelgröße für die Stabilisierung des Prozesses geeignet.

Der Informationsgehalt der harmonischen Analyse wird durch mehrere Material- und Prozeßparameter bestimmt, so daß die optimale Regelgröße anhand von separaten Untersuchungen am jeweiligen Einzelfall in der dem Fachmann geläufigen Weise ermittelt werden kann.

In einem weiteren Ausführungsbeispiel wurde ein reaktiver MF-Sputterprozeß für Nb₂O₅ mittels der Bestimmung der ersten Oberwelle der Targetspannung stabilisiert. Die technische Umsetzung erfolgte hierbei mit einem 1-Phasen-Lock-in-Verstärker, dessen Referenz und Signaleingang mit der Targetspannung gespeist wurde. Durch den Betrieb im 2F-Modus wurde von dem Lock-in-Verstärker der Oberwellenanteil der Targetspannung ausgegeben. Dieser Oberwellenanteil wurde auf die vom Generator gelieferte Targetspannung normiert, so daß in erster Näherung der normierte Fourierkoeffizient bei der ersten Oberwelle gemessen wurde. Anschließend wurde diese Regelgröße bei konstanter Sauerstoffzufuhr (25sccm) stabilisiert, indem die elektrische Leistung an der Kathode als Stellgröße variiert wurde.

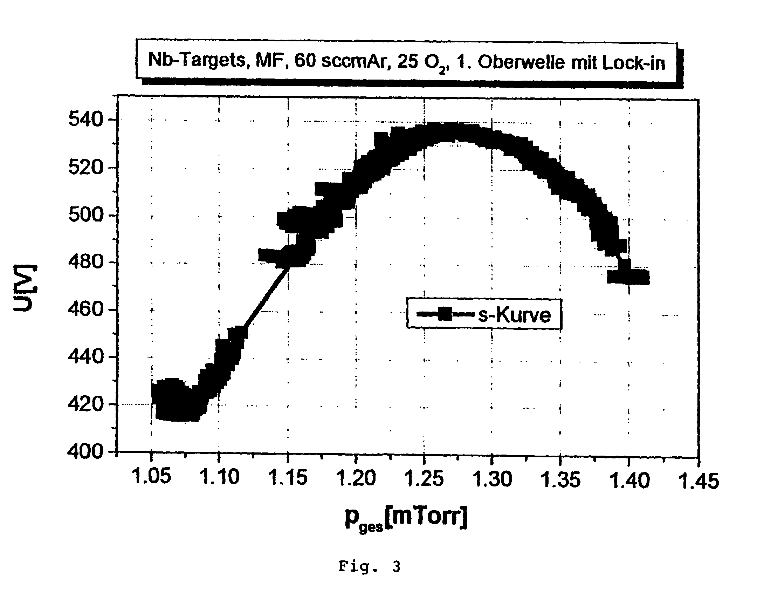

Figur 3 zeigt die Abhängigkeit der Entladespannung von dem Gesamtdruck in der Sputterkammer. Wie zu erkennen ist, weist die Kennlinie keinen monotonen Zusammenhang auf. Da keine monotone Beziehung zwischen den Entladungsparametern und den Schichteigenschaften bzw. dem Raktivgas-Partialdruck besteht, ist der reaktive NbOₓ-Sputterprozeß nicht impedanzregelbar.

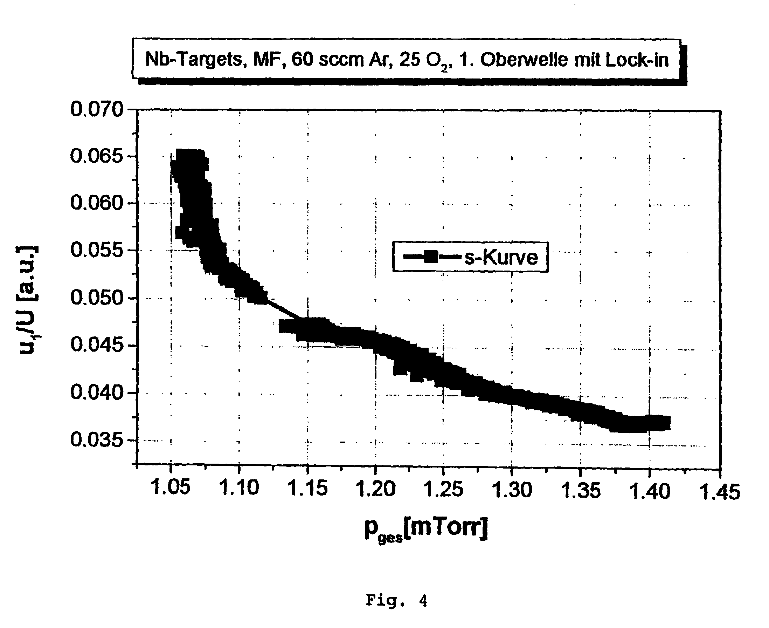

Figur 4 stellt demgegenüber die Abhängigkeit des wie oben beschriebenen normierten Fourierkoeffizienten u1/U von dem Totaldruck dar. u1 bezeichnet dabei die Amplitude der ersten Oberwelle des am Target abgegriffenen Verlaufs der Targetspannung U₍ₜ₎, wobei U der Mittelwert der vom Generator gegebenen Spannung ist. Hier ist zu erkennen, daß dieser normierte Fourierkoeffizient und der Totaldruck einen monotonen Zusammenhang aufweisen. Folglich ist es mit dieser Regelgröße möglich, Schichten bei stetig veränderbarem Reaktivgas-Partialdruck im Übergangsmodus herzustellen.

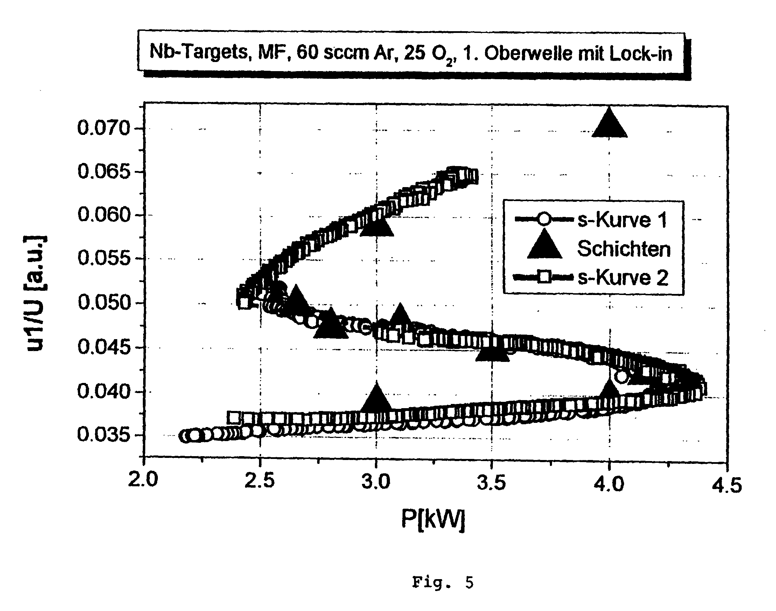

Figur 5 zeigte die Kennlinie der Abhängigkeit des normierten Fourierkoeffizienten u1/U von der Entladungsleistung. Man erkennt die typische S-Form der Kennlinie. Es gibt keinen unstetigen Übergang und daher kann die Entladung an jedem Arbeitspunkt stabilisiert werden.

In Figur 5 sind weiterhin die Arbeitspunkte eingetragen, an denen Schichten aus NbOₓ hergestellt wurden (gefüllte Dreiecke).

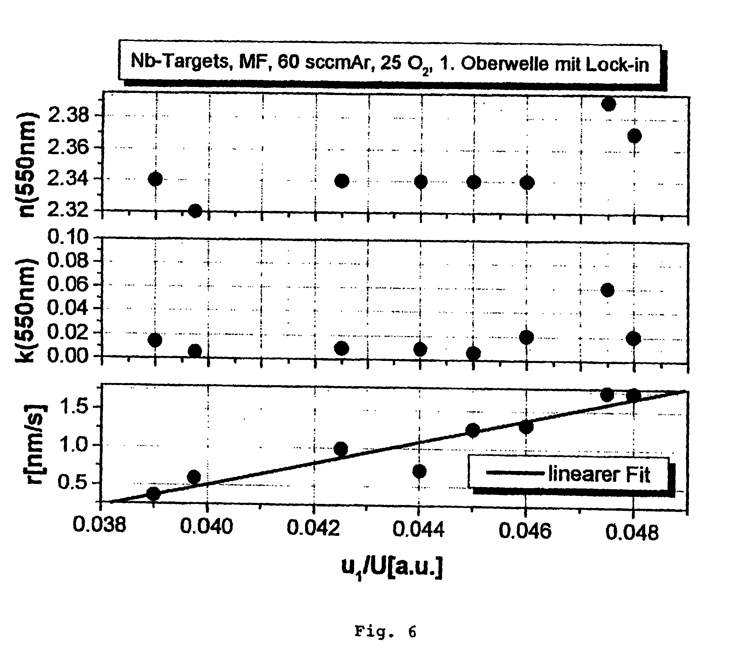

Figur 6 zeigt die optischen Konstanten, Brechungsindex n und Absorptionsindex k, sowie die Depositionsrate a der Proben, die an den markierten Arbeitspunkten der Fig. 3 hergestellt wurden. Wie zu erkennen ist, beginnen die Proben oberhalb eines Wertes von u1/U von ca. 0,047 zu absorbieren. Transparente Schichten entstanden für u1/U = 0,046 bei einer hohen Depositionsrate von a = 1,25 nm/s im instabilen Parameterbereich des mittleren Zweiges der S-Kurve aus Fig. 5.

Die Werte bei 0,044 und 0,048 sind als Ausreißer zu betrachten.

Es bleibt hier noch anzumerken, daß die Regelung in diesem Fall auf nur einer Kathode arbeitete, so daß die zweite Kathode einen geringfügig anderen Zustand haben konnte, was jedoch nichts an der prinzipiellen Funktion der Regelung änderte.

Zusammenfassend läßt sich feststellen, daß erstmals ein Verfahren zur Stabilisierung des reaktiven MF-Magnetronsputterns sowie des HF- bzw. MF-Sputterns im sog. Übergangsbereich zur Verfügung gestellt wird, welches auf der harmonischen Analyse der elektrischen Parameter basiert.

## Patentansprüche

1. Verfahren zur Regelung von MF- oder HF-Sputterprozessen,
**dadurch gekennzeichnet, daß** eine harmonische Analyse der elektrischen Entladungsparameter durchgeführt wird und aufgrund der Analyseresultate die MF- bzw. HF-Leistung und/oder der Reaktivgasfluß geregelt wird.

2. Verfahren nach dem vorhergehenden Anspruch,
**dadurch gekennzeichnet, daß** aus den Analyseresultaten eine Regelgröße bestimmt wird und die MF- bzw. HF-Leistung so geregelt wird, daß die Regelgröße ihren Sollwert annimmt.

3. Verfahren nach einem der vorhergehenden Ansprüche,
**dadurch gekennzeichnet, daß** eine harmonische Analyse des komplexen Fourierspektrums des Targetstroms und/oder der Targetspannung durchgeführt wird.

4. Verfahren nach einem der vorhergehenden Ansprüche,
**dadurch gekennzeichnet, daß** eine Analyse der Phasenverschiebung zwischen Targetstrom und Targetspannung bei der Fundamentalfrequenz und/oder bei Oberwellen durchgeführt wird.

5. Verfahren nach einem der vorhergehenden Ansprüche,
**dadurch gekennzeichnet, daß** eine Analyse der Verhältnisse der Fourierkoeffizienten von Targetstrom und/oder Targetspannung durchgeführt wird.

6. Verfahren nach einem der vorhergehenden Ansprüche,
**dadurch gekennzeichnet, daß** als Regelgröße der auf die Targetspannung normierte Fourierkoeffizient der ersten Oberwelle der Targetspannung bestimmt wird.

7. Vorrichtung zum Durchführen von MF- oder HF-Sputterprozessen mit einer Sputterkammer und einer Kathode, auf der das zu zerstäubende Target angeordnet ist, und einem Generator zur Erzeugung einer MF- oder HF-Spannung an der Kathode
**gekennzeichnet durch** eine Vorrichtung zur Durchführung einer harmonischen Analyse der elektrischen Entladungsparameter nach einem der vorhergehenden Ansprüche sowie eine Vorrichtung zur Regelung der MF- bzw. HF-Leistung aufgrund der Analyseergebnisse.

## Claims

1. A method of regulating MF or HF sputtering processes,
**characterised in that** a harmonic analysis of the electrical discharge parameters is performed and the MF or HF power and/or the reactive-gas flow are regulated on the basis of the analytical results.

2. A method according to the preceding claim,
**characterised in that** a controlled variable is determined from the analytical results and the MF or HF power is regulated in such a way that the controlled variable assumes its set value.

3. A method according to one of the preceding claims,
**characterised in that** a harmonic analysis of the complex Fourier spectrum of the target current and/or of the target voltage is performed.

4. A method according to one of the preceding claims,
**characterised in that** an analysis of the phase shift between target current and target voltage is performed at the fundamental frequency and/or at harmonics.

5. A method according to one of the preceding claims,
**characterised in that** an analysis of the relationships of the Fourier coefficients of target current and/or target voltage is performed.

6. A method according to one of the preceding claims,
**characterised in that** the Fourier coefficient of the first harmonic of the target voltage, normalised to the target voltage, is determined as the controlled variable.

7. A device for performing MF or HF sputtering processes with a sputtering chamber and a cathode on which the target to be sprayed is placed, and with a generator for generating an MF or HF voltage at the cathode,
**characterised by** a device for performing a harmonic analysis of the electrical discharge parameters according to one of the preceding claims and a device for regulating the MF or HF power on the basis of the analytical results.

## Revendications

1. Procédé de régulation de processus de pulvérisation MF ou HF, **caractérisé en ce qu'**on exécute une analyse harmonique des paramètres de décharge électriques et qu'on règle la puissance MF ou HF et/ou le flux de gaz réactif sur la base des résultats de l'analyse.

2. Procédé selon la revendication 1, **caractérisé en ce qu'**on détermine une grandeur de régulation à partir des résultats de l'analyse et qu'on règle la puissance MF ou HF de manière que la valeur de régulation prenne sa valeur de consigne.

3. Procédé selon l'une des revendications précédentes, **caractérisé en ce qu'**on exécute une analyse harmonique du spectre de Fourier complexe du courant de et/ou de la tension de la cible.

4. Procédé selon l'une des revendications précédentes, **caractérisé en ce qu'**on exécute une analyse du déphasage entre le courant de la cible et la tension de la cible pour la fréquence fondamentale et/ou pour des harmoniques.

5. Procédé selon l'une des revendications précédentes, **caractérisé en ce qu'**on exécute une analyse des conditions des coefficients de Fourier du courant de la cible et/ou de la tension de la cible.

6. Procédé selon l'une des revendications précédentes, **caractérisé en ce qu'**on détermine comme grandeur réglée, le coefficient de Fourier, qui est normalisé en étant rapporté à la tension de la cible, du premier harmonique de la tension de la cible.

7. Dispositif pour la mise en oeuvre du processus de pulvérisation MF ou HF comportant une chaNre de pulvérisation et une cathode, sur laquelle est disposée la cible à pulvériser, et un générateur pour produire une tension MF ou HF au niveau de la cathode, **caractérisé par** un dispositif pour la mise en oeuvre d'une analyse harmonique du paramètre de décharge électrique selon l'une des revendications précédentes, ainsi qu'un dispositif pour la régulation de la puissance MF ou HF sur la base des résultats de l'analyse.
